# EUROPÄISCHE PATENTSCHRIFT

(11) **EP 2 220 689 B1**
(45) Veröffentlichungstag und Bekanntmachung des Hinweises auf die Patenterteilung: **27.08.2014**
(21) Anmeldenummer: 08850615.9
(22) Anmeldetag: 06.11.2008
(51) Int. Cl.: H01L 31/18, H01L 31/0216, H01L 31/068

(54) **VERFAHREN ZUM HERSTELLEN EINER SOLARZELLE MIT EINER OBERFLÄCHENPASSIVIERENDEN DIELEKTRIKUMDOPPELSCHICHT UND ENTSPRECHENDE SOLARZELLE**
METHOD FOR MANUFACTURING A SOLAR CELL WITH A SURFACE-PASSIVATING DIELECTRIC DOUBLE LAYER, AND CORRESPONDING SOLAR CELL
PROCÉDÉ DE FABRICATION D'UNE CELLULE SOLAIRE COMPORTANT UNE DOUBLE COUCHE DE DIÉLECTRIQUE À PASSIVATION DE SURFACE, ET CELLULE SOLAIRE CORRESPONDANTE

(30) Priorität: 14.11.2007 DE 102007054384
(43) Veröffentlichungstag der Anmeldung: 25.08.2010
(73) Patentinhaber: Institut für Solarenergieforschung GmbH, 31860 Emmerthal (DE); Technische Universiteit Eindhoven, 5612 AZ Eindhoven (NL)
(72) Erfinder: SCHMIDT, Jan, 31789 Hameln (DE); HOEX Bram Dr., 159012 Singapore (SG)
(74) Vertreter: Qip Patentanwälte Dr. Kuehn & Partner mbB
(86) Internationale Anmeldenummer: PCT/EP2008/065067
(87) Internationale Veröffentlichungsnummer: WO 2009/062882

(56) Entgegenhaltungen:
- EP-A- 1 489 667
- US-A1- 2006 157 733
- HOEX B ET AL: "Excellent passivation of highly doped p-type Si surfaces by the negative-charge-dielectric Al2O3" 11. September 2007 (2007-09-11), APPLIED PHYSICS LETTERS, AIP, AMERICAN INSTITUTE OF PHYSICS, MELVILLE, NY, US, PAGE(S) 112107 - 112107 , XP012099144 ISSN: 0003-6951 das ganze Dokument
- HAVERKAMP H ET AL: "A Process Design for the Production of IBC Solar Cells on Multi-Crystalline Silicon", 2006 IEEE 4TH WORLD CONFERENCE ON PHOTOVOLTAIC ENERGY CONVERSION, 1 May 2006 (2006-05-01), pages 1365-1367, XP031007570, ISBN: 978-1-4244-0016-4
- LEE ET AL: "Investigation of various surface passivation schemes for silicon solar cells", SOLAR ENERGY MATERIALS AND SOLAR CELLS, ELSEVIER SCIENCE PUBLISHERS, AMSTERDAM, NL, vol. 90, no. 1, 6 January 2006 (2006-01-06), pages 82-92, XP005149780, ISSN: 0927-0248, DOI: DOI:10.1016/J.SOLMAT.2005.02.007
- ULYASHIN A G ET AL: "Hydrogen Release and Defect Formation During Heat Treatments of SiNx:H/a-Si: H Double Passivation Layer on C-SI Substrate", 2006 IEEE 4TH WORLD CONFERENCE ON PHOTOVOLTAIC ENERGY CONVERSION, 1 May 2006 (2006-05-01), pages 1354-1357, XP031007567, ISBN: 978-1-4244-0016-4
- TUCCI M ET AL: "Characterization of SiNx/a-Si:H Crystalline Silicon Surface Passivation Under UV Light Exposure", 21ST EUROPEAN PHOTOVOLTAIC SOLAR ENERGY CONFERENCE , DRESDEN, GERMANY, 4 - 8 SEPTEMBER 2006, WIP RENEWABLE ENERGIES, MÜNCHEN, 4 September 2006 (2006-09-04), pages 1404-1407, XP040512455, ISBN: 978-3-936338-20-1

## Beschreibung

### BEREICH DER ERFINDUNG

Die vorliegende Erfindung betrifft ein Verfahren zum Herstellen einer Solarzelle mit einer oberflächenpassivierenden Dielektrikumdoppelschicht und eine entsprechende Solarzelle.

### HINTERGRUND DER ERFINDUNG

Eine entscheidende Voraussetzung, um bei Solarzellen hohe Wirkungsgrade zu erreichen, ist eine sehr effektive Unterdrückung von Oberflächenrekombinationsverlusten. Zu diesem Zwecke sollte die Oberfläche von Solarzellen möglichst gut passiviert werden, sodass Ladungsträgerpaare, die im Innern der Solarzelle durch einfallendes Licht erzeugt werden und die an die Oberflächen des Solarzellensubstrates diffundieren, nicht an der Solarzellenoberfläche rekombinieren, wodurch sie einem Beitrag zum Wirkungsgrad der Solarzelle nicht mehr zur Verfügung stünden.

Bei Laborsolarzellen wird dieses Problem häufig durch Aufwachsen von Siliziumdioxid bei hoher Temperatur (z.B. >900°C) gelöst. Da ein solcher Hochtemperatur-Prozessschritt einen erheblichen Mehraufwand in der Solarzellenprozessierung bedeutet, wird bei der industriellen Solarzellenherstellung derzeit jedoch meist auf eine solche Art der Oberflächenpassivierung verzichtet.

Eine weitere Schwierigkeit der Hochtemperaturoxidation ist die Empfindlichkeit von kostengünstigerem multikristallinen Silizium gegenüber hohen Temperaturen, die in diesem Material zu einer erheblichen Reduzierung der Materialqualität, d.h. der Ladungsträgerlebensdauer, und damit zu Wirkungsgradverlusten führen können.

Eine Niedertemperatur-Alternative ist die Oberflächenpassivierung mit amorphem Siliziumnitrid oder Siliziumkarbid, die bei Temperaturen von 300-400°C beispielsweise mittels plasmaunterstützter chemischer Gasphasenabscheidung (Plasma Enhanced Chemical Vapour Deposition, PECVD) hergestellt werden können. Eine solche Oberflächenpassivierung ist z.B. beschrieben in T. Lauinger et al.: "Record low surface recombination velocities on 1 Ωcm p-silicon using remote plasma silicon nitride passivation", Appl. Phys. Lett. 68, 1232-1234 (1996); und in I. Martin et al.: "Surface passivation ofp-type crystalline silicon by plasma enhanced chemical vapor deposited amorphous SiCx films", Appl. Phys. Lett. 79, 2199-2201 (2001). Die auf diese Weise hergestellten dielektrischen Schichten sind für großflächige Hocheffizienz-Solarzellen jedoch nur begrenzt einsetzbar, da sie eine hohe Dichte sogenannter "Pinholes", d.h. kleine Löcher oder Poren in der Schicht, enthalten können, und sie folglich nicht gut isolierend sein können. Außerdem basiert ihre Passivierwirkung größtenteils auf einer sehr hohen positiven Ladungsdichte innerhalb der dielektrischen Schichten, die bei der Passivierung z.B. der Solarzellenrückseite bei der Verwendung von p-Typ Siliziumwafern zur Ausbildung einer Inversionsschicht führen kann, über die ein zusätzlicher Verluststrom von Minoritätsladungsträgern aus der Basis der Solarzelle zu den Rückseitenkontakten abfließen kann (sogenannter "parasitärer Shunt"). Auf hoch bordotierten p⁺-Silizium-Oberflächen kann Siliziumnitrid aufgrund der hohen positiven Ladungsdichte sogar zu einer Depassivierung im Vergleich zu einer unpassivierten p⁺-Oberfläche führen.

Sehr gute Passivierungen sowohl auf p- als auch auf p⁺-Ober .flächen wurden mit amorphen Siliziumschichten erzielt, die ebenfalls mittels plasmaunterstützter Gasphasenabscheidung bei sehr niedrigen Beschichtungstemperaturen (typischerweise < 250°C), hergestellt werden können, wie dies z.B. in S. Dauwe et al.: "Very low surface recombination velocities on p-and n-type silicon wafers passivated with hydrogenated amorphous silicon films", Proc. 29th IEEE Photovoltaic Specialists Conf., New Orleans, USA (2002), p. 1246; und in P. Altermatt et al.: "The surface recombination velocity at boron-doped emitters: comparison between various passivation techniques", Proceeding of the 21st European Photovoltaic Solar Energy Conference, Dresden (2006), p. 647 beschrieben ist.

Die oberflächenpassivierende Eigenschaft solcher amorphen Siliziumschichten kann jedoch sehr anfällig gegenüber Temperaturbehandlungen sein. Bei heutigen industriellen Solarzellenprozessen erfolgt die Metallisierung häufig mittels Siebdrucktechnik, wobei typischerweise als letzter Prozessschritt eine Feuerung der Kontakte in einem Infrarot-Durchlaufofen bei Temperaturen zwischen ca. 800°C und 900°C stattfindet. Obwohl die Solarzelle diesen hohen Temperaturen nur für wenige Sekunden ausgesetzt ist, kann dieser Feuerschritt zu einer erheblichen Degradation der Passivierwirkung der amorphen Siliziumschichten führen.

Gute Passivierergebnisse können auch mit Aluminiumoxidschichten erzielt werden, die mittels sequentieller Gasphasenabscheidung (Atomic Layer Deposition, ALD) bei z.B. etwa 200°C abgeschieden und anschließend bei etwa 425°C getempert werden. Allerdings wird bei der sequentiellen Gasphasenabscheidung innerhalb eines Abscheidungszyklus jeweils generell nur eine einzelne Moleküllage des abzuscheidenden Materials auf der Substratoberfläche angelagert. Da ein Abscheidungszyklus typischerweise etwa 0.5 bis 4s dauert, ergeben sich entsprechend niedrige Abscheideraten. Die Abscheidung von Aluminiumoxidschichten mit einer Dicke, die für eine Verwendung als Antireflexschicht oder als Rückseitenreflektor geeignet ist, erfordert daher Abscheidungsdauern, die eine Verwendung solcher Schichten bei industriell gefertigten Solarzelle bisher als kommerziell uninteressant erscheinen ließen,

US 2006/157733 A1 sowie Hoex et al.: "Excellent passivation of highly doped p-type Si surfaces by negative-charge-dielectric Al2O3", 11. September 2007 (2007-09-11), Applied Physics Letters vol. 91, page 112107, offenbaren Verfahren zum Passivieren einer Siliziumoberfläche einer Solarzelle, umfassend das Abscheiden einer aus Aluminiomoxid bestehenden Dielektrikumschicht.

### ZUSAMMENFASSUNG DER ERFINDUNG

Es kann ein Bedarf an einer Solarzelle und an einem Herstellungsverfahren für eine Solarzelle bestehen, bei der/dem einerseits eine gute Passivierung der Oberfläche der Solarzelle erreicht werden kann und andererseits die obengenannten Nachteile herkömmlicher oberflächenpassivierender Schichten zumindest teilweise vermieden werden können. Insbesondere soll die Möglichkeit einer kostengünstigen, industriell realisierbaren Fertigung von Solarzelle mit einer sehr guten Oberflächenpassivierung geschaffen werden.

Dieser Bedarf kann durch den Gegenstand der unabhängigen Ansprüche erfüllt werden. Vorteilhafte Ausführungsformen der vorliegenden Erfindung sind in den abhängigen Ansprüchen beschrieben.

Gemäß einem ersten Aspekt der vorliegenden Erfindung wird ein Verfahren zum Herstellen einer Siliziumsolarzelle vorgeschlagen, aufweisend die folgenden Schritte; Bereitstellen eines Siliziumsubstrats; Abscheiden einer ersten Dielektrikumschicht an einer Oberfläche des Siliziumsubstrates mittels sequentieller Gasphasenabscheidung, wobei die erste Dielektrikumschicht Aluminiumoxid aufweist; und Abscheiden einer zweiten Dielektrikumschicht an einer Oberfläche der ersten Dielektrikumschicht, wobei sich die Materialien der ersten und der zweiten Dielektrikumschicht unterscheiden und wobei in die zweite Dielektrikumschicht Wasserstoff eingelagert ist.

Dieser erste Aspekt der vorliegenden Erfindung kann als auf der folgenden Idee basierend angesehen werden: es wird ein Verfahren zur Herstellung von Siliziumsolarzellen mit einer dielektrischen Passivierschicht zur Verminderung von Oberflächenrekombinationsverlusten angegeben. Die dielektrische Passivierschicht setzt sich aus zwei Teilschichten zusammen, aus einer sehr dünnen Aluminiumoxid-haltigen Schicht, die mit sequentieller Gasphasenabscheidung (Atomic Layer Deposition, ALD) gebildet wird, sowie aus einer dickeren Schicht z.B. aus Siliziumoxid, Siliziumnitrid oder Siliziumkarbid, die z.B. mittels plasmaunterstützter chemischer Gasphasenabscheidung (Plasma Enhanced Chemical Vapour Deposition, PECVD) auf der Aluminiumoxidschicht deponiert werden kann.

Die bei dem Verfahren gemäß dem ersten Aspekt erzeugte Dielektrikumdoppelschicht ermöglicht die Passivierung sowohl hoch als auch niedrig dotierter Bereiche der Solarzellenoberfläche vom Leitungstyp p oder n. Es kann eine stabile Passivierung ermöglicht werden, die ihre passivierenden Eigenschaften auch nach einem Feuerschritt im Temperaturbereich 800-900°C zum Einbrennen von Metallkontakten beibehält. Gleichzeitig kann die dielektrische Passivierschicht auch vorteilhafte optische Eigenschaften haben, d.h. für die Aufbringung auf der Solarzellenvorderseite kann die Schicht als effektive Antireflexschicht dienen, bei Aufbringung auf der Solarzellenrückseite kann die Passivierschicht zusammen mit einer ganzflächigen Rückseitenmetallisierung einen effektiven Spiegel für Photonen mit Energien nahe der Silizium-Bandlücke bilden, um das sogenannte "Light Trapping", d.h. das Einfangen von Licht durch mehrfache interne Reflexion, in der Solarzelle zu verbessern. Weiterhin kann für die Rückseitenpassivierung auf Standard-Solarzellen-Halbleitermaterial vom Leitungstyp p der vom Siliziumnitrid her bekannte negative Effekt des "parasitären Shuntings" vermieden werden.

Der Schlüssel für das Verständnis der ausgezeichneten Passivierwirkung und Temperstabilität der erfindungsgemäßen Stapelschicht kann in der Kombination der im Idealfall atomar ebenen Si/Al₂O₃-Grenzfläche, die beim ALD-Prozess naturgemäß entsteht, und der stark wasserstoffhaltigen SiOₓ-, SiNₓ- oder SiCₓ-Schichten, wie sie sich z.B. beim PECVD-Prozess bilden, gesehen werden. Ein Teil des Wasserstoffs aus den PECVD-abgeschiedenen Schichten kann durch die ultradünne Al₂O₃-Schicht diffundieren und an der Grenzfläche zum Silizium unabgesättigte Silizium-Bindungen passivieren.

Merkmale, Einzelheiten und mögliche Vorteile von Ausführungsformen des erfindungsgemäßen Herstellungsverfahrens werden im Anschluss erläutert.

Bei dem bereitgestellten Siliziumsubstrat kann es sich um eine dünne monokristalline oder multikristalline Siliziumscheibe ("Wafer") oder auch um eine Siliziumdünnschicht handeln.

Bei der zu beschichtenden Oberfläche kann es sich um die im Einsatz dem einfallenden Licht zugewandte Vorderseite des Solarzellensubstrates handeln. In diesem Fall wird die zweite Dielektrikumschicht vorzugsweise als Antireflexschicht aufgebracht, d.h. mit einer Dicke, bei der es für das einfallende und reflektierte Licht zu negativen Interferenzen kommt. Die Dicke kann im Bereich von etwa 50 bis 150nm gewählt werden, je nach Brechungsindex des für die zweite Dielektrikumschicht verwendeten Materials.

Alternativ kann es sich bei der zu beschichtenden Oberfläche um die im Einsatz vom einfallenden Licht abgewandte Rückseite des Solarzellensubstrates handeln. In diesem Fall wird die zweite Dielektrikumschicht vorzugsweise als sogenannter Rückseitenreflektor ausgebildet, sodass Licht, insbesondere infrarotes Licht, das die gesamte Solarzelle durchdringt, an dieser Rückseite weitestgehend refl-ektiert wird und somit das Solarzellensubstrat ein weiteres Mal durchläuft.

Vor dem Abscheiden der ersten Dielektrikumschicht kann die Oberfläche des Siliziumsubstrates gründlich gereinigt werden, damit keine Verschmutzungen auf ihr zurückbleiben, die die anschließend abgeschiedene Dielektrikumschicht stören könnten. Insbesondere kann die Oberfläche des Siliziumsubstrates geringfügig abgeätzt werden, beispielsweise in einer Lösung, die einerseits ein oxidierendes Mittel enthält und die andererseits Flusssäure (HF) enthält, die das oxidierte Siliziumoxid abätzt. Eine geeignete in der Solarzellenfertigung bekannte Reinigungsmethode ist z.B. die sogenannte RCA-Reinigung.

Gemäß einer Ausführungsform des erfindungsgemäßen Verfahrens wird für die sequentielle Gasphasenabscheidung der ersten Dielektrikumschicht das Siliziumsubstrat zunächst mit einer Aluminium-haltigen Verbindung, die wenigstens eine der Komponenten Al(CH₃)₃, Ach, Al(CH₃)₂C1 und (CH₃)₂(C₂H₅)N:AlH₃ aufweist, umspült, sodass sich an der Oberfläche des Siliziumsubstrates eine Aluminium-haltige Schicht ablagert. Nachfolgend wird die Aluminium-haltige Schicht in einer Sauerstoff-haltigen Atmosphäre aufoxidiert.

Bei dem Umspülen des Siliziumsubstrates mit der Aluminium-haltigen Verbindung kann sich die Aluminium-haltige Verbindung an den Stellen, an denen sie mit der Siliziumoberfläche in Kontakt kommt, an die Siliziumoberfläche anhaften. Es kann zu einer chemischen Reaktion mit der Siliziumoberfläche kommen, was auch als Chemisorption bezeichnet wird. Dadurch kann sich eine im Idealfall monomolekulare Lage aus Molekülen der Aluminium-haltigen Verbindung bilden. Vorteilhaft kann hierbei sein, dass diese Moleküllage annähernd perfekt dicht sein kann, d.h. das bei richtiger Wahl der Prozessparameter, wie Dauer und Temperatur beim Umspülen, die gesamte Siliziumoberflächen mit Molekülen der Aluminium-haltigen Verbindung bedeckt ist. Somit kann die anschließend entstehende erste Dielektrikumschicht im Wesentlichen atomar bzw. molekular dicht sein.

In einem nachfolgenden Prozessschritt wird die zuvor angelagerte Moleküllage der Aluminium-haltigen Verbindung aufoxidiert. Dies kann zum Beispiel durch umspülen mit Sauerstoff oder einem Sauerstoff-haltigen Gas geschehen. Um die chemischen Reaktionen zu beschleunigen, kann der Sauerstoff in Form eines energiereichen O₂-Plasmas zur Verfügung gestellt werden (plasma-unterstützte Abscheidung), wobei es vorteilhaft sein kann, das O₂-Plasma nicht direkt über den Substraten sondern in einer separaten Kammer zu zünden und dann zu den Substraten zu leiten (sogenanntes "remote plasma ALD"). Alternativ kann der Sauerstoff bei hohen Temperaturen eingeleitet werden (thermisch unterstützte Abscheidung). Es bildet sich hieraufhin eine Schicht, die zumindest Al₂O-Moleküle enthält und die vorzugsweise vollständig aus Al₂O₃-Molekülen besteht. Auf diese Weise kann eine im Wesentlichen monomolekulare Lage aus Al₂O₃-Molekülen mit einer Dicke von etwa 1,2 Angström (0,12nm) abgeschieden werden.

Der vorangehend beschriebene Prozess kann mehrfach wiederholt werden, um eine ausreichende Dicke der Aluminiumoxidschicht zu erreichen. Dabei wird genutzt, dass die Moleküle der Aluminium-haltigen Verbindung zwar nicht auf sich selbst haften können, wohl aber auf den anschließend aufoxidierten Aluminiumoxidmolekülen. Somit kann die erste Dielektrikumschicht Lage um Lage aufgebaut werden, wodurch eine sehr gute Homogenität und damit Qualität der Schicht bewirkt werden kann.

Der gesamte sequentielle Abscheidungsprozess kann in einer gemeinsamen Kammer durchgeführt werden, in die zunächst die Aluminium-haltige Verbindung eingeleitet wird, die anschließend gespült wird und in die nachfolgend die Sauerstoff-haltige Atmosphäre eingeleitet wird, bevor der Vorgang dann wiederholt von vorne beginnen kann.

Ein wesentlicher Vorteil der sequentiellen Gasphasenabscheidung ist, dass die gesamte Substratoberfläche gleichmäßig beschichtet wird. Die Abscheidung erfolgt unabhängig von der Geometrie der Substratoberfläche, d.h. sie ist oberflächenkonform. Daher wird die erste Dielektrikumschicht überall mit der gleichen Dicke abgeschieden. Dies ist insbesondere bei oberflächentexturierten Solarzellen oder bei Solarzellen mit Kanälen, die die Frontseite mit der Rückseite der Solarzelle elektrisch kontaktieren sollen (sogenannte EWT- Solarzellen (emitter wrap through)) günstig, da eine Passivierung der gesamten relevanten Solarzellenoberfläche sichergestellt werden kann.

Gemäß einer Ausführungsform des erfindungsgemäßen Verfahrens weist die zweite Dielektrikumschicht Siliziumnitrid, Siliziumoxid und/oder Siliziumkarbid auf. Diese Materialien weisen sehr gute optische Eigenschaften wie z.B. eine hohe Transparenz nahezu im gesamten Sonnenspektrum auf. Sie eignen sich daher insbesondere als Antireflexschicht. Ferner können Dielektrikumschichten aus diesen Materialien einen hohen Wasserstoffanteil enthalten, was zur weiteren Passivierung der Solarzelle beitragen kann.

Gemäß einer Ausführungsform des erfindungsgemäßen Verfahrens wird die zweite Dielektrikumschicht mittels eines PEGVD-Verfahrens hergestellt. Dieses Verfahren, bei dem Reaktanten wie z.B. Silan (SiH₄), Distickstoffoxid (N₂O), Kohlendioxid (CO₂), Ammoniak (NH₄) und/oder Methan (CH₄) durch Zünden eines Plasmas zur Reaktion gebracht werden, kann qualitativ hochwertige Dielektrikumschichten aus Siliziumnitrid, Siliziumoxid oder Siliziumkarbid erzeugen, die zudem einen hohen Wasserstoffanteil aufweisen können.

Gemäß einer Ausführungsform des erfindungsgemäßen Verfahrens wird die zweite Dielektrikumschicht derart abgeschieden, dass sie einen Wasserstoffanteil von wenigstens 1 at%, vorzugsweise wenigstens 2 at% und stärker bevorzugt wenigstens 5 at% aufweist. Der eingelagerte Wasserstoff kann zumindest teilweise durch die darunterliegende erste Dielektrikumschicht hindurch diffundieren und dort durch Absättigen von freien Bindungen des Siliziums ("dangling bonds") zur Passivierung beitragen. Es hat sich herausgestellt, dass dieser Beitrag sogar noch höher sein kann als in dem Fall, bei dem eine Wasserstoff-haltiges Dielektrikum direkt auf einer Siliziumoberfläche abgeschieden wird.

Gemäß einer Ausführungsform des erfindungsgemäßen Verfahrens wird nach dem Abscheiden der zweiten Dielektrikumschicht ein Hochtemperaturschritt bei Temperaturen oberhalb von 600°C, vorzugsweise oberhalb von 700°C und stärker bevorzugt oberhalb von 800°C durchgeführt. Ein solcher Hochtemperaturschritt kann z.B. dazu verwendet werden, um bei einer Weiterprozessierung der Solarzelle Metallkontakte, die zuvor mittels Siebdruck auf die Solarzellenoberfläche aufgedruckt wurden, in diese einzufeuern. Der Hochtemperaturschritt kann hierbei den weiteren Vorteil haben, dass in der zweiten Dielektrikumschicht enthaltener Wasserstoff bei den erhöhten Temperaturen leicht durch die erste Dielektrikumschicht hindurch diffundieren und noch freie Bindungen des Siliziums absättigen kann, was zu einer weiteren Verbesserung der Passivierwirkung führen kann .

Gemäß einer Ausführungsform des erfindungsgemäßen Verfahrens wird die erste Dielektrikumschicht mit einer Dicke von weniger als 50nm, vorzugsweise weniger als 30nm und stärker bevorzugt weniger als 10nm abgeschieden. Die erste Dielektrikumschicht bietet bereits bei sehr geringen Dicken aufgrund ihrer durch die sequentielle Gasphasenabscheidung erreichbaren hohen Qualität sehr gute Oberflächen-passivierende Eigenschaften. Je dünner die Schicht ist, umso schneller kann sie abgeschieden werden, wobei jedoch eine Mindestdicke von etwa 0,5nm, vorzugsweise etwa 2nm nicht unterschritten werden sollte, um eine Dichtheit der Schicht zu gewährleisten.

Gemäß einer Ausführungsform des erfindungsgemäßen Verfahrens wird die zweite Dielektrikumschicht mit einer Dicke von mehr als 50nm, vorzugsweise mehr als 100nm und stärker bevorzugt mehr als 200nm abgeschieden. Wie bereits oben beschrieben, kann die Dicke der zweiten Dielektrikumschicht auf ihre Aufgabe als Antireflexschicht oder Rückseitenreflektor abgestimmt sein.

Gemäß einem zweiten Aspekt der vorliegenden Erfindung wird eine Solarzelle vorgeschlagen, aufweisend ein Siliziumsubstrat; eine erste Dielektrikumschicht, die Aluminiumoxid aufweist, an einer Oberfläche des Siliziumsubstrates; und eine zweite Dielektrikumschicht an einer Oberfläche der ersten Dielektrikumschicht, wobei sich die Materialien der ersten und der zweiten Dielektrikumschicht unterscheiden und wobei in die zweite Dielektrikumschicht Wasserstoff eingelagert ist.

Es wird angemerkt, dass die Ausführungsformen, Merkmale und Vorteile der Erfindung hauptsächlich in Bezug auf das erfindungsgemäße Herstellungsverfahren beschrieben wurden. Ein Fachmann wird jedoch aus der vorangehenden und auch aus der nachfolgenden Beschreibung erkennen, dass, sofern dies nicht anders angegeben ist, die Ausführungsformen und Merkmale der Erfindung auch analog auf die erfindungsgemäße Solarzelle übertragen werden können. Insbesondere können die Merkmale der verschiedenen Ausführungsformen auch in beliebiger Weise untereinander kombiniert werden.

Zusammenfassend zeichnet sich das Verfahren bzw. die Solarzelle gemäß Aspekten und Ausführungsformen der vorliegenden Erfindung gegenüber bereits bekannten Verfahren zur Oberflächenpassivierung kristalliner Siliziumsolarzellen bzw. derart beschichteten Solarzellen unter anderem durch die folgenden Punkte aus:
(i) es kann eine für die Realisierung hoher Solarzellenwirkungsgrade erforderliche sehr gute Oberflächenpassivierung auch nach einem Feuerschritt im Temperaturbereich 800-900°C erreicht werden;
(ii) sowohl niedrig als auch hoch dotierte n- und p-Typ Siliziumoberflächen können sehr gut passiviert werden;
(iii) aufgrund der hohen negativen Ladungsdichte in der Al₂O₃-Schicht auf p-Typ Silizium wird keine Inversionsschicht unterhalb der Passivierschicht im Silizium induziert, wodurch der schädliche Effekt eines "parasitären Shunts" im Wesentlichen vermieden werden kann;
(iv) die Schichten sind frei von Pinholes;
(v) es können in einfacher Weise sehr gute optische Eigenschaften des Schichtsystems erreicht werden, die sehr einfach über die Dicke und die Zusammensetzung der z.B. PECVD-abgeschiedenen Schicht an die Erfordernisse der Solarzelle angepasst werden können, so dass das Schichtsystem z.B. als Antireflexschicht auf der Solarzellenvorderseite oder als Infrarot-Reflektor auf der Solarzellenrückseite in Kombination mit ganzflächiger Metallisierung auf der Passivierschicht ausgebildet werden kann.

### KURZE BESCHREIBUNG DER ZEICHNUNGEN

Weitere Merkmale und Vorteile der vorliegenden Erfindung werden dem Fachmann aus der nachfolgenden Beschreibung einer beispielhaften Ausführungsform, die jedoch nicht als die Erfindung beschränkend auszulegen ist, und unter Bezugnahme auf die begleitende Zeichnung ersichtlich.

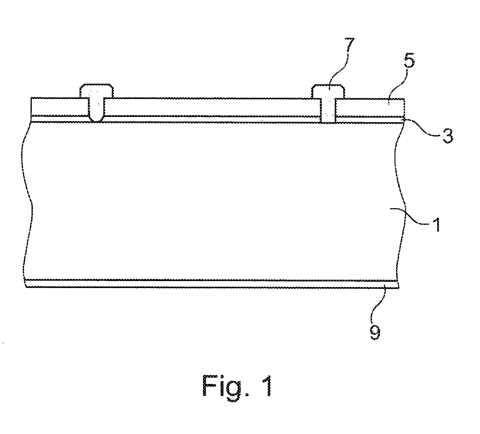

Fig. 1 veranschaulicht schematisch eine Solarzelle gemäß einer Ausführungsform der vorliegenden Erfindung.

### DETAILLIERTE BESCHREIBUNG VON AUSFÜHRUNGSFORMEN

Nachfolgend wird eine beispielhafte Ausführungsform des erfindungsgemäßen Herstellungsverfahrens angegeben.

Eine noch nicht fertig zur Solarzelle prozessierte Siliziumscheibe 1, in die z.B. zuvor ein Emitter an einer Oberfläche eindiffundiert wurde und deren Oberfläche gründlich gereinigt wurde, wird in eine evakuierte Beschichtungskammer eingebracht und eine Al-haltige Verbindung wie z.B. Al(CH₃)₃ wird als Reaktant in die Kammer eingespeist. Durch Chemisorption lagern sich die Moleküle des Reaktanten an die Siliziumoberfläche an, bis die Oberfläche gesättigt ist. Die nicht chemisorbierten Moleküle des Reaktanten werden nachfolgend aus der Kammer entfernt, z.B. indem die Kammer mit einem Spülgas wie z.B. Stickstoff gespült wird.

Anschließend wird ein O₂-Plasma oberhalb der zu passivierenden Siliziumoberfläche bzw. in einer separaten Kammer gezündet und die Sauerstoffradikale reagieren mit den chemisorbierten Molekülen zu Al₂O₃. Es bildet sich eine im Idealfall mono-molekulare Aluminiumoxidschicht. Die Temperatur der Siliziumscheibe wird dabei möglichst konstant auf einer Temperatur gehalten, die im Bereich zwischen Raumtemperatur und 450°C liegt.

Nach einem solchen Zyklus wird die Beschichtungskammer wieder evakuiert und ein erneuter Zyklus begonnen. Dieser Prozess wird wiederholt, bis die gewünschte Dicke der Al₂O₃-Schicht erreicht ist. Um die Gesamtbeschichtungsdauer möglichst gering zu halten, wird die Schichtdicke der Al₂O₃-Schicht 3 auf etwa 5 nm begrenzt, d.h. der ALD-Beschichtungsprozeß wird etwa 40 bis 50 Mal wiederholt, sodass sich eine Gesamtbeschichtungsdauer von etwa 20 bis 200s ergibt.

Die hier beschriebene Variante der ALD wird als "Plasma-Assisted ALD" bezeichnet und ist aus der Literatur gut bekannt, siehe z.B. C. W. Jeong et al., Plasma-assisted atomic layer growth of high-quality aluminum oxide thin films, Jpn. J. Appl. Phys. 40, 285-289 (2001). Versuche haben ergeben, dass eine besonders gute Oberflächenpassivierung dadurch erreicht werden kann, dass das Plasma keinen direkten Kontakt zu den Substraten hat, da es bei einem solchen Kontakt durch Ionenbombardement zu einer Schädigung der Substratoberflächen kommen kann, sondern in einer separaten Kammer, von der aus die Radikale anschließend zur Substratoberfläche geleitet werden, brennt. Diese Verfahrensvariante wird als "remote plasma-assisted ALD" bezeichnet und ist z.B. beschrieben in US 7,410,671.

Alternativ kann die Al₂O₃-Dünnschicht 3 auch mittels thermischer ALD abgeschieden werden, wie in der Literatur z.B. beschrieben in M. Ritala et al., Atomic layer deposition of oxide thin films with metal alkoxides as oxygen sources, Science 288, 319-321 (2000).

Die auf der Siliziumscheibe abgeschiedene Al₂O₃-Dünnschicht 3 wird anschließend in einem PECVD-Reaktor mit einer Siliziumoxid-Dünnschicht 5 in einem kontinuierlichen Prozess bei hoher Beschichtungsrate beschichtet. Die Beschichtungstemperatur liegt dabei im Bereich zwischen Raumtemperatur und 450°C. Die verwendeten Gase sind SiH₄ und N₂O.

N₂O kann dabei auch durch CO₂ ersetzt werden. Außerdem ist es möglich durch Austausch des N₂O geg NH₄ eine Siliziumnitridschicht abzuscheiden oder durch Austausch des N₂O gegen CH₄ eine Siliziumkarbidschicht abzuscheiden. Erfolgt die Abscheidung bei Temperaturen unterhalb von 400°C , kann ein nachträgliches Tempern für ca. 30 min im Temperaturbereich von 400-500°C positiv wirken, um die optimale Passivierqualität des Schichtsystems zu erreichen.

Abschließend werden Metallkontakte 7, 9 auf die Frontseite und die Rückseite des beschichteten Siliziumsubstrates aufgebracht, beispielsweise mittels Siebdruck, und in einem Durchlaufofen bei etwa 700 - 900°C eingefeuert.

Zusammenfassend und mit anderen Worten können Aspekte der vorliegenden Erfindung wie folgt beschrieben werden:
Es wird ein Verfahren zur Bildung einer Stapelschicht vorgeschlagen, wobei die Stapelschicht aus zwei Teilschichten besteht:
   (i) einer sehr dünnen (z.B. ≤ 10 nm) Aluminiumoxid-Dünnschicht, die durch sequentielle Gasphasenabscheidung (Atomic Layer Deposition, ALD) aus einem Aluminium-haltigen Gas (z.B. Trimethylaluminium Al(CH₃)₃) gebildet wird, sowie
   (ii) einer dickeren (> 30 nm) Siliziumoxid-haltigen Dünnschicht, die z.B. mittels plasmaunterstützter chemischer Gasphasenabscheidung (Plasma Enhanced Chemical Vapour Deposition, PECVD) aus den Gasen Silan (SiH₄) und Distickstoffoxid (N₂O) bzw. Kohlendioxid (CO₂) gebildet werden kann.

Die zweite Schicht kann an Stelle einer Siliziumoxid-Dünnschicht auch eine Siliziunnitridhaltige Dünnschicht sein, die aus den Gasen Silan (SiH₄) und Ammoniak (NH₄) mittels PECVD gebildet wird, oder eine Siliziumkarbid-haltige Dünnschicht, die aus den Gasen Silan (SiH₄) und Methan (CH₄) gebildet wird. Die mittels PECVD abgeschiedenen Dünnschichten aus Siliziumoxid, Siliziumnitrid oder Siliziumkarbid haben einen sehr hohen Wasserstoffgehalt (z.B. >5 at.%) und dienen daher während eines Feuerschritts im Temperaturbereich 700-900°C als Wasserstoffquelle. Der Wasserstoff diffundiert durch die ultradünne Al₂O₃-Schicht und passiviert an der Si/Al₂O₃-Grenzfläche unabgesättigte Silizium-Bindungen ("Dangling Bonds"), was zu einer sehr guten Oberflächenpassivierung nach dem Feuerschritt führt. Durch die erfindungsgemäße Kombination der beiden bekannten Abscheideverfahren ALD und PECVD wird es so ermöglicht, eine für Solarzellen optimal geeignete feuerstabile Passivierschicht zu bilden.

## Patentansprüche

1. Verfahren zum Herstellen einer Siliziumsolarzelle, aufweisend die folgenden Schritte:
Bereitstellen eines Siliziumsubstrats (1);
Abscheiden einer ersten Dielektrikumschicht (3) an einer Oberfläche des Siliziumsubstrates mittels sequentieller Gasphasenabscheidung, wobei die erste Dielektrikumschicht Aluminiumoxid aufweist; **gekennzeichnet durch**
Abscheiden einer zweiten Dielektrikumschicht (5) an einer Oberfläche der ersten Dielektrikumschicht (3), wobei sich die Materialien der ersten und der zweiten Dielektrikumschicht unterscheiden und wobei in die zweite Dielektrikumschicht Wasserstoff eingelagert ist.

2. Verfahren nach Anspruch 1, wobei zum Abscheiden der ersten Dielektrikumschicht das Siliziumsubstrat zunächst mit einer Aluminium-haltigen Verbindung, die wenigstens eine der Komponenten Al(CH₃)₃, AlCl₃, Al(CH₃)₂Cl und (CH₃)₂(C₂H₅)N:AlH₃ aufweist, umspült wird, sodass sich an der Oberfläche des Siliziumsubstrates eine Aluminium-haltige Schicht ablagert, und wobei die Aluminium-haltige Schicht nachfolgend in einer Sauerstoff-haltigen Atmosphäre aufoxidiert wird.

3. Verfahren nach einem der Ansprüche 1 oder 2, wobei die zweite Dielektrikumschicht ein Material ausgewählt aus der Gruppe umfassend Siliziumnitrid, Siliziumoxid und Siliziumkarbid aufweist.

4. Verfahren nach einem der Ansprüche 1 bis 3, wobei die zweite Dielektrikumschicht mittels eines PECVD-Verfahrens hergestellt wird.

5. Verfahren nach einem der Ansprüche 1 bis 4, wobei die zweite Dielektrikumschicht derart abgeschieden wird, dass sie einen Wasserstoffanteil von wenigstens 1 at%, vorzugsweise wenigstens 2 at% und stärker bevorzugt wenigstens 5 at% aufweist.

6. Verfahren nach einem der Ansprüche 1 bis 5, wobei nach dem Abscheiden der zweiten Dielektrikumschicht ein Hochtemperaturschritt bei Temperaturen oberhalb von 600°C, vorzugsweise oberhalb von 700°C und stärker bevorzugt oberhalb von 800°C durchgeführt wird.

7. Verfahren nach einem der Ansprüche 1 bis 6, wobei die erste Dielektrikumschicht mit einer Dicke von weniger als 50nm, vorzugsweise weniger als 30nm und stärker bevorzugt weniger als 10nm abgeschieden wird.

8. Verfahren nach einem der Ansprüche 1 bis 7, wobei die zweite Dielektrikumschicht mit einer Dicke von mehr als 50nm, vorzugsweise mehr als 100nm und stärker bevorzugt mehr als 150nm abgeschieden wird.

9. Solarzelle aufweisend:
ein Siliziumsubstrat (1);
eine erste Dielektrikumschicht (3), die Aluminiumoxid aufweist, an einer Oberfläche des Siliziumsubstrates (1);
**gekennzeichnet durch**
eine zweite Dielektrikumschicht (5) an einer Oberfläche der ersten Dielektrikumschicht (3), wobei sich die Materialien der ersten und der zweiten Dielektrikumschicht unterscheiden und wobei in die zweite Dielektrikumschicht Wasserstoff eingelagert ist.

10. Solarzelle nach Anspruch 9, wobei die erste Dielektrikumschicht mittels sequentieller Gasphasenabscheidung abgeschieden ist, so dass sie im wesentlichen atomar dicht ist.

11. Solarzelle nach Anspruch 9 oder 10, wobei die zweite Dielektrikumschicht ein Material ausgewählt aus der Gruppe umfassend Siliziumnitrid, Siliziumoxid und Siliziumkarbid aufweist.

12. Solarzelle nach einem der Ansprüche 9 bis 11, wobei die erste Dielektrikumschicht eine Dicke von weniger als 50nm, vorzugsweise weniger als 30nm und stärker bevorzugt weniger als 10nm aufweist.

13. Solarzelle nach einem der Ansprüche 9 bis 12, wobei die zweite Dielektrikumschicht eine Dicke von mehr als 50nm, vorzugsweise mehr als 100nm und stärker bevorzugt mehr als 150nm aufweist.

## Claims

1. Method for production of a silicon solar cell, comprising the following steps:
provision of a silicon substrate (1);
deposition of a first dielectric layer (3) on a surface of the silicon substrate by means of atomic layer deposition, wherein the first dielectric layer comprises aluminium oxide;
**characterized by**
deposition of a second dielectric layer (5) on a surface of the first dielectric layer (3), wherein the materials of the first and second dielectric layer differ and wherein hydrogen is included in the second dielectric layer.

2. Method according to claim 1, wherein to deposit the first dielectric layer, the silicon substrate is first flushed with an aluminium-containing compound comprising at least one of the components Al(CH₃)₃, AlCl₃, Al(CH₃)₂Cl and (CH₃)₂(C₂H₅)N:AlH₃, so that an aluminium-containing layer is deposited on the surface of the silicon substrate, and wherein the aluminium-containing layer is then oxidized in an oxygen-containing atmosphere.

3. Method according to any of claims 1 or 2, wherein the second dielectric layer comprises a material selected from the group comprising silicon nitride, silicon oxide and silicon carbide.

4. Method according to any of claims 1 to 3, wherein the second dielectric layer is produced using a PECVD method.

5. Method according to any of claims 1 to 4, wherein the second dielectric layer is deposited such that it has a hydrogen content of at least 1 at%, preferably at least 2 at% and more preferably at least 5 at%.

6. Method according to any of claims 1 to 5, wherein after deposition of the second dielectric layer, a high temperature step is carried out at temperatures above 600°C, preferably above 700°C and more preferably above 800°C.

7. Method according to any of claims 1 to 6, wherein the first dielectric layer is deposited with a thickness of less than 50nm, preferably less than 30nm and more preferably less than 10nm.

8. Method according to any of claims 1 to 7, wherein the second dielectric layer is deposited with a thickness of more than 50nm, preferably more than 100nm and more preferably more than 150nm.

9. Solar cell comprising:
a silicon substrate (1);
a first dielectric layer (3) comprising aluminium oxide on a surface of the silicon substrate (1);
**characterized by**
a second dielectric layer (5) on a surface of the first dielectric layer (3), wherein the materials of the first and second dielectric layers differ and wherein hydrogen is included in the second dielectric layer.

10. Solar cell according to claim 9, wherein the first dielectric layer is deposited by means of atomic layer deposition so that it is substantially tight on an atomic scale.

11. Solar cell according to claim 9 or 10, wherein the second dielectric layer is selected from a group comprising silicon nitride, silicon oxide and silicon carbide.

12. Solar cell according to any of claims 9 to 11, wherein the first dielectric layer has a thickness of less than 50nm, preferably less than 30nm and more preferably less than 10nm.

13. Solar cell according to any of claims 9 to 12, wherein the second dielectric layer has a thickness of more than 50nm, preferably more than 100nm and more preferably more than 150nm.

## Revendications

1. Procédé de fabrication d'une cellule solaire en silicium, présentant les étapes suivantes :
- la fourniture d'un substrat en silicium (1) ;
- le dépôt d'une première couche diélectrique (3) sur une surface du substrat en silicium au moyen d'un dépôt séquentiel en phase gazeuse (atomic layer déposition), la première couche diélectrique présentant de l'oxyde d'aluminium ;
**caractérisé par**
- le dépôt d'une seconde couche diélectrique (5) sur une surface de la première couche diélectrique (3), les matériaux de la première et de la seconde couche diélectrique étant distincts et de l'hydrogène étant contenu dans la seconde couche diélectrique.

2. Procédé selon la revendication 1, dans lequel, pour le dépôt de la première couche diélectrique, le substrat en silicium étant d'abord trempé dans un composé contenant de l'aluminium, qui présente au moins un des composants Al(CH₃)₃, AlCl₃, Al(CH₃)₂C1 et (CH₃)₂(C₂H₅)N:AlH₃, de telle sorte qu'une couche contenant de l'aluminium se dépose sur la surface du substrat de silicium, et la couche contenant de l'aluminium étant ensuite oxydée dans une atmosphère contenant de l'oxygène.

3. Procédé selon l'une des revendications 1 ou 2, la seconde couche diélectrique présentant un matériau choisi parmi le groupe comprenant du nitrure de silicium, de l'oxyde de silicium et du carbure de silicium.

4. Procédé selon l'une des revendications 1 à 3, la seconde couche diélectrique étant fabriquée au moyen d'un procédé PECVD.

5. Procédé selon l'une des revendications 1 à 4, la seconde couche diélectrique étant déposée de telle sorte qu'elle présente une teneur en hydrogène d'au moins 1 at%, préférentiellement d'au moins 2 at% et encore plus préférentiellement d'au moins 5 at%.

6. Procédé selon l'une des revendications 1 à 5, une étape à haute température étant réalisée, après le dépôt de la seconde couche diélectrique, à des températures au-dessus de 600 °C, préférentiellement au-dessus de 700 °C et plus préférentiellement au-dessus de 800 °C.

7. Procédé selon l'une des revendications 1 à 6, la première couche diélectrique étant déposée avec une épaisseur inférieure à 50 nm, préférentiellement inférieure à 30 nm et encore plus préférentiellement inférieure à 10 nm.

8. Procédé selon l'une des revendications 1 à 7, la seconde couche diélectrique étant déposée avec une épaisseur supérieure à 50 nm, préférentiellement supérieure à 100 nm et encore plus préférentiellement supérieure à l50 nm.

9. Cellule solaire présentant :
- un substrat en silicium (1) ;
- une première couche diélectrique (3), qui présente de l'oxyde d'aluminium, sur une surface du substrat de silicium (1) ;
**caractérisée par**
- une seconde couche diélectrique (5) sur une surface de la première couche diélectrique (3), les matériaux de la première et de la seconde couche diélectrique étant distincts et de l'hydrogène étant contenu dans la seconde couche diélectrique.

10. Cellule solaire selon la revendication 9, la première couche diélectrique étant déposée au moyen d'un dépôt séquentiel en phase gazeuse, de telle sorte qu'elle est essentiellement atomiquement dense.

11. Cellule solaire selon la revendication 9 ou 10, la seconde couche diélectrique présentant un matériau choisi parmi le groupe comprenant du nitrure de silicium, de l'oxyde de silicium et du carbure de silicium.

12. Cellule solaire selon l'une des revendications 9 à 11, la première couche diélectrique présentant une épaisseur inférieure à 50 nm, préférentiellement inférieure à 30 nm et encore plus préférentiellement inférieure à 10 nm.

13. Cellule solaire selon l'une des revendications 9 à 12, la seconde couche diélectrique présentant une épaisseur supérieure à 50 nm, préférentiellement supérieure à 100 nm et encore plus préférentiellement supérieure à 150 nm.
